# EUROPEAN PATENT APPLICATION

(11) **EP 4 495 997 A2**
(43) Date of publication of application: **22.01.2025**
(21) Application number: 24188455.0
(22) Date of filing: 12.07.2024
(51) Int. Cl.: H01L 25/065, H01L 23/498, H01L 23/538, H01L 25/10, H01L 25/18

(54) **SEMICONDUCTOR PACKAGE INCLUDING MULTIPLE DIES COMMUNICATING WITH EACH OTHER THROUGH A DIE-TO-DIE INTERCONNECT**

(30) Priority: 20.07.2023 KR 20230094522
(71) Applicant: Samsung Electronics Co., Ltd, Suwon-si, Gyeonggi-do 16677 (KR)
(72) Inventor: LEE, TagGun, 16677 Suwon-si (KR); PARK, Donguk, 16677 Suwon-si (KR); SUH, Youngseob, 16677 Suwon-si (KR)
(74) Representative: Marks & Clerk LLP

(57) **Abstract**

A semiconductor package includes first and second dies that transmit and/or receive signals with each other. The semiconductor package includes a package substrate, at least one first die on the package substrate and connected to the package substrate with an interposer therebetween, and at least one second die on the package substrate and connected to the package substrate. Each of the first and second dies includes a transmitter and a receiver, each including data lanes, and the number of the data lanes of the transmitter and/or the receiver of the first die is different from the number of the data lanes of the transmitter and/or the receiver of the second die.

## Description

### BACKGROUND

Example embodiments of the present disclosure described herein relate to semiconductor packages, and more particularly, relate to semiconductor packages including a plurality of dies.

Recently, various types of chiplets are being developed to improve the performance of semiconductor devices and to manufacture the semiconductor devices with high yields in the semiconductor manufacturing industry.

The chiplets including multiple dies communicate with each other through a die-to-die interconnect. The die-to-die interconnect between the dies is implemented by bumps. However, the die-to-die communication is limited depending on the pitch of the bumps, and thus, there are difficulties in configuring the chiplets.

### SUMMARY

Example embodiments of the present disclosure provide semiconductor packages capable of allowing dies having different types of interconnects to communicate with each other.

According to some example embodiments, the semiconductor package comprises: first and second dies that transmit and/or receive signals with each other; a package substrate; and an interposer, wherein: the first die is on the package substrate and connected to the package substrate with the interposer therebetween; and the second die is on the package substrate and connected to the package substrate, each of the first and second dies comprising a transmitter and a receiver, each comprising data lanes, and a number of the data lanes of the transmitter and/or the receiver of the first die is different from a number of the data lanes of the transmitter and/or the receiver of the second die.

The first die may transmit signals that are received by the second die. The second die may transmit signals that are received by the first die.

A number of the data lanes of the transmitter and/or the receiver of the first die is different from a number of the data lanes of the transmitter and/or the receiver of the second die. For example, a number of data lanes of at least one of the transmitter or the receiver of the first die may be different from a number of the data lanes of at least one of the transmitter or the receiver of the second die.

In some embodiments, the semiconductor package further comprises: first bumps connected to the data lanes corresponding to the transmitter and the receiver of the first die; and second bumps connected to the data lanes corresponding to the transmitter and the receiver of the second die. The first bumps may be between the first die and the interposer, and the second bumps may be between the second die and the package substrate and between the package substrate and the interposer. A first subset of the second bumps (which belong to a third interconnect) may be between the second die and the package substrate, whilst a second subset of the second bumps (which belong to a second interconnect) may be between the package substrate and the interposer.

According to some example embodiments, a semiconductor package including first and second dies that transmit and/or receive signals with each other includes a package substrate, at least one the first die on the package substrate and connected to the package substrate with an interposer therebetween, and at least one the second die on the package substrate and connected to the package substrate. Each of the first and second dies includes a transmitter and a receiver, each including data lanes, and the number of the data lanes of the transmitter and/or the receiver of the first die is different from the number of the data lanes of the transmitter and/or the receiver of the second die.

The semiconductor package further includes first bumps connected to the data lanes corresponding to the transmitter and the receiver of the first die and second bumps connected to the data lanes corresponding to the transmitter and the receiver of the second die.

The first bumps have a pitch different from a pitch of the second bumps.

The first bumps are between the first die and the interposer, and the second bumps are between the second die and the package substrate and between the package substrate and the interposer. The interposer includes a plurality of vias through which the first bumps are connected to the second bumps.

The number of the data lanes of the second die is smaller than the number of the data lanes of the first die.

The semiconductor package further includes a remapping unit configured to remap the signals input thereto in a different order from an input order of the signals and output the remapped signals to corresponding data lanes, respectively, in response to the signals being transmitted between the data lanes of the first die and the data lanes of the second die.

The transmitter and/or the receiver of each of the first and second dies includes input data lanes configured to receive signals, the remapping unit configured to remap and provide the signals of the input data lanes to output data lanes, and the output data lanes configured to receive the remapped signals from the remapping unit and output the remapped signals.

The remapping unit is provided to each of the transmitter and the receiver of the first die.

The remapping unit includes first and second remapping units respectively provided to the transmitter and the receiver of the first die and third and fourth remapping units respectively provided to the transmitter and the receiver of the second die.

The output data lanes of the transmitter of the first die are physically connected to the input data lanes of the receiver of the second die.

The first remapping unit is configured to select the data lanes physically connected to the input data lanes of the receiver of the second die among the output data lanes of the transmitter of the first die and provide the signals.

The semiconductor package further includes at least one third die on the interposer and/or the package substrate and connected to at least one of the first and second dies.

Each of the first die and/or the second die includes at least one of a logic semiconductor device or a memory semiconductor device.

According to some example embodiments, a semiconductor package includes a package substrate, a first die on the package substrate and connected to the package substrate by a first interconnect, and a second die on the package substrate and connected to the package substrate by a second interconnect. The first interconnect includes first bumps arranged at a first pitch, the second interconnect includes second bumps arranged at a second pitch different from the first pitch, and at least one of the first and second dies includes a remapping unit configured to allocate signals arranged in a first order to the first bumps of the first interconnect and/or the second bumps of the second interconnect in a second order different from the first order.

Each of the first and second dies includes a transmitter and a receiver, each including data lanes, and the number of the data lanes of the transmitter and/or the receiver of the first die is different from the number of the data lanes of the transmitter and/or the receiver of the second die.

The transmitter and/or the receiver of each of the first and second dies includes input data lanes configured to receive signals, the remapping unit configured to remap and provide the signals of the input data lanes to output data lanes, and the output data lanes configured to receive the remapped signals from the remapping unit and output the remapped signals.

Based on the number of the data lanes of the transmitter and the receiver of the first die is n and the number of the data lanes of the transmitter and the receiver of the second die is m being smaller than the n (n>m), the remapping unit is configured to select m data lanes corresponding to a case where the first bumps are physically connected to the second bumps among the n data lanes and provides the signals.

The remapping unit includes first and second remapping units respectively provided to the transmitter and the receiver of the first die and third and fourth remapping units respectively provided to the transmitter and the receiver of the second die.

According to some example embodiments, a method of transmitting signals from a first die to a second die includes allowing input data lanes to be set in a first order corresponding to signals to be transmitted in a transmitter of the first die, allowing a first remapping unit to select output data lanes in a second order, outputting the signals to a receiver of the second die through the selected output data lanes, allowing the receiver of the second die to receive the signals output from the first die through input data lanes in a third order, and allowing a second remapping unit to select output data lanes in the first order and to output the signals.

According to some example embodiments, the semiconductor package enables a die-to-die communication between dies having different types from each other is provided.

According to some example embodiments, the semiconductor package enables a die-to-die communication between a 2.5D type die and a 2D type die.

At least some of the above and other features of the invention are set out in the claims.

### BRIEF DESCRIPTION OF THE FIGURES

The above and other objects and features of the present disclosure will become apparent by describing in detail example embodiments thereof with reference to the accompanying drawings.
FIG. 1A is a plan view illustrating a semiconductor package according to some example embodiments of the present disclosure.
FIG. 1B is a cross-sectional view taken along a line A-A' of FIG. 1A.
FIGS. 2A and 2B are plan views schematically illustrating first bumps and second bumps, respectively.
FIG. 3 is a view schematically illustrating a signal transmission between a first die and a second die in a semiconductor package according to some example embodiments of the present disclosure.
FIGS. 4A and 4B are views schematically illustrating an interface between a first die and a second die with data lanes.
FIGS. 5A and 5B are views illustrating a physical connection relationship between first bumps and second bumps, FIG. 5A illustrates a connection relationship that is physically possible, and FIG. 5B illustrates a connection relationship that is not physically possible.
FIGS. 6A and 6B are views schematically illustrating a signal transmission process from a first die to a second die in a semiconductor package according to some example embodiments of the present disclosure.
FIGS. 7A and 7B are views schematically illustrating a signal transmission process from a first die to a second die in a semiconductor package according to some example embodiments of the present disclosure.
FIGS. 8A and 8B are views schematically illustrating a signal transmission process from a first die to a second die in a semiconductor package according to some example embodiments of the present disclosure.
FIG. 9A is a view illustrating a semiconductor package in which six dies are provided on a package substrate according to some example embodiments of the present disclosure.
FIG. 9B is a cross-sectional view taken along a line B-B' of FIG. 9A.
FIGS. 10A and 10B are views illustrating a semiconductor package according to some example embodiments of the present disclosure, and some of dies on an interposer are 3D devices stacked three-dimensionally.
FIG. 11 is a cross-sectional view illustrating an electronic system employing a semiconductor package according to some example embodiments of the present disclosure.

### DETAILED DESCRIPTION

The present disclosure may be variously modified and realized in many different forms, and thus specific example embodiments will be shown in the drawings and described in detail hereinbelow. However, the present disclosure should not be limited to the specific disclosed forms, and be construed to include all modifications, equivalents, or replacements included in the scope of the present disclosure.

According to some example embodiments of the present disclosure, a chiplet-type semiconductor package includes at least two dies, and the at least two dies and an interposer are disposed on a package substrate. According to some example embodiments of the present disclosure, one die of the at least two dies is disposed on the interposer, and the other die of the two or more dies is disposed on the package substrate. That is, the semiconductor package according to some example embodiments of the present disclosure corresponds to a hybrid type semiconductor package that is a mixture of a two-dimensional (2D) semiconductor package in which dies of various functions are arranged on the package substrate and a two-and-a-half dimensional (2.5D) semiconductor package in which dies of various functions are arranged by using the interposer. According to some example embodiments of the present disclosure, the semiconductor package includes a remapping unit that selects and remaps data lanes between two dies disposed on different substrates (the package substrate and the interposer), so that a signal transmission between the die provided on the interposer and the die provided on the package substrate is enabled. For example, according to some example embodiments, there may be an increase in speed, accuracy, and/or power efficiency of chip to chip communication and operation of the device based on the above methods. Therefore, the improved devices and methods overcome the deficiencies of the conventional devices and methods of chiplet-type semiconductor packages related to including different types of semiconductor packages while reducing resource consumption and increasing data clarity. Further, there is a size and/or compactness improvement by providing the ability for different types of semiconductor packages to communicate on a chiplet-type semiconductor package as discussed herein.

Hereinafter, example embodiments of the present disclosure will be described in more detail with reference to accompanying drawings.

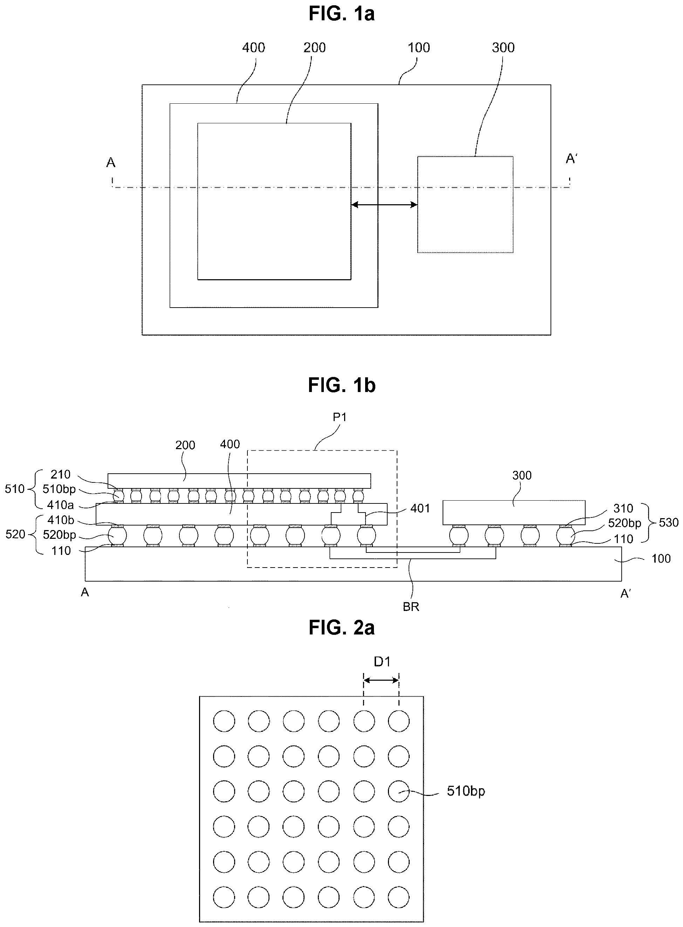

FIG. 1A is a plan view illustrating a semiconductor package according to some example embodiments of the present disclosure, and FIG. 1B is a cross-sectional view taken along a line A-A' of FIG. 1A.

Referring to FIGS. 1A and 1B, the semiconductor package may include a package substrate 100, an interposer 400 disposed above the package substrate 100, at least one first die 200 disposed above the package substrate 100 and connected to the package substrate 100 with the interposer 400 interposed therebetween, and at least one second die 300 disposed above the package substrate 100 and connected to the package substrate 100.

The package substrate 100 may be a support substrate on which the first die 200, the second die 300, and the interposer 400 are mounted. The package substrate 100 may include at least one layer of lines therein or may include multiple layers of lines. In the case where the lines are provided in the multiple layers, the lines disposed on different layers may be connected to each other through vertical contacts. According to some example embodiments, the package substrate 100 may include various lines, and may further include, for example, bridge lines BR connecting a second interconnect 520 and a third interconnect 530, which are described later.

The package substrate 100 may have various types of redistribution lines formed on one or both surfaces of a core layer that is formed of, for example, an organic material, such as phenolic resin, epoxy resin, polyimide, etc., or a reinforced fiber glass. However, materials for the core layer of the package substrate 100 should not be limited thereto or thereby. According to some example embodiments, the package substrate 100 may be a substrate of a ceramic material, e.g., a silicon wafer. In some example embodiments, the redistribution lines may include a conductive material, such as copper (Cu), aluminum (Al), silver (Ag), tin (Sn), gold (Au), nickel (Ni), lead (Pb), titanium (Ti), or alloys thereof, however, materials for the redistribution lines should not be limited thereto or thereby. The redistribution lines may be disposed on an upper surface and a lower surface and inside of the core layer.

Pads 110 may be provided on an upper surface and/or a lower surface of the package substrate 100 for connection with other components.

The interposer 400 may convert or transmit digital signals between the first die 200 and the package substrate 100. The first die 200 may be stacked on the package substrate 100 with the interposer 400 interposed therebetween.

The interposer 400 may include a silicon substrate or a glass substrate, however, the interposer 400 should not be limited thereto or thereby. As an example, the interposer 400 may be manufactured using an organic substrate. In some example embodiments, the silicon substrate will be described as the interposer 400.

The interposer 400 may include a plurality of lines and a plurality of vias 401 connecting an upper surface and a lower surface of the interposer 400. The vias 401 may be through silicon vias (TSV). The interposer 400 may have a back-end-of-the-line (BEOL) structure, however, it should not be limited thereto or thereby. According to some example embodiments, the interposer 400 may have a front-end-of-the-line (FEOL) structure. The redistribution lines may be provided in various forms on the upper surface and/or the lower surface of the interposer 400, and the interposer 400 may include not only the redistribution lines but also active or passive devices.

The first and/or second dies 200 and 300 may be various integrated circuit (IC) devices. The IC devices may include active devices and/or passive devices, and may include various devices, such as a logic semiconductor device, a memory semiconductor device, etc. The logic semiconductor device may perform various signal processing operations, such as an analog signal processing operation, an analog-to-digital (A/D) conversion operation, a control operation, etc. For instance, the logic semiconductor device may be an application processor (AP), a micro-processor, a central processing unit (CPU), a controller, a graphic processor unit (GPU), or an application specific integrated circuit (ASIC). In addition, the memory semiconductor device may be, for example, a volatile memory such as a dynamic random access memory (DRAM), a static random access memory (SRAM), etc., or a non-volatile memory such as a phase-change random access memory (PRAM), a magneto-resistive random access memory (MRAM), a ferroelectric random access memory (FeRAM), a resistive random access memory (RRAM).

The first die 200, the second die 300, the interposer 400, and the package substrate 100 may be connected to each other by an interconnect and thus may be electrically connected to each other. The interconnect may include pads and bumps.

The interconnect may be provided between the interposer 400 and the first die 200, between the package substrate 100 and the interposer 400, and between the second die 300 and the interposer 400.

When the interconnect between the interposer 400 and the first die 200, the interconnect between the package substrate 100 and the interposer 400, and the interconnect between the second die 300 and the package substrate 100 are respectively referred to as a first interconnect 510, a second interconnect 520, and a third interconnect 530, the first interconnect 510 may include pads 210 and 410a respectively provided on the first die 200 and the interposer 400 facing the first die 200 and first bumps 510bp provided between the pads 210 of the first die 200 and the pads 410a on the interposer 400 to connect the pads 210 of the first die 200 and the pads 410a of the interposer 400. The second interconnect 520 may include pads 410b and 110 respectively provided on the interposer 400 and the package substrate 100 facing the interposer 400 and second bumps 520bp provided between the pads 410b of the interposer 400 and the pads 110 of the package substrate 100 to connect the pads 410b of the interposer 400 and the pads 110 of the package substrate 100. According to some example embodiments, the third interconnect 530 may be provided on the same package substrate 100 as the second interconnect 520. The third interconnect 530 may include pads 310 and 110 respectively provided on the second die 300 and the package substrate 100 facing the second die 300 and second bumps 520bp provided between the pads 310 of the second die 300 and the pads 110 of the package substrate 100 to connect the pads 310 of the second die 300 and the pads 110 of the package substrate 100.

The first bumps 510bp may transmit signals between the first die 200 and the interposer 400 and may be connected to data lanes (not shown) of the first die 200 and data lanes (not shown) of the interposer 400. The second bumps 520bp may transmit signals between the interposer 400 and the package substrate 100 and may be connected to the data lanes (not shown) of the interposer 400 and data lanes (not shown) of the package substrate 100. In addition, the second bumps 520bp may transmit signals between the second die 300 and the package substrate 100 and may be connected to data lanes (not shown) of the second die 300 and the data lanes (not shown) of the package substrate 100.

In some example embodiments, the first and second bumps 510bp and 520bp may be provided to correspond to the data lanes of components to be connected, that is, the first die 200, the second die 300, the package substrate 100, the interposer 400, etc.

The number of the data lanes of each of the first die 200, the second die 300, the package substrate 100, and the interposer 400 may be varied depending on configuration and specification of an interface. As an example, in the case where the signals are transmitted through the first interconnect, the number of the data lanes may be 39, and in the case where the signals are transmitted through the second interconnect, the number of the data lanes may be ten (10). However, the number of the data lanes should not be particularly limited and may be varied depending on an interface employed when the signals are transmitted.

In this case, the first and second bumps 510bp and 520bp may correspond to the data lanes of the components to be connected, for example, the first die 200, the second die 300, the package substrate 100, and the interposer 400, in a one-to-one correspondence or a one-to-many correspondence. The number of the bumps corresponding to and connected to the data lanes should not be particularly limited and may be greater than the number of the data lanes.

According to the present disclosure, each of the first and second bumps 510bp and 520bp may be a solder bump, however, the first and second bumps 510bp and 520bp should not be limited thereto or thereby. According to some example embodiments, other types of connection elements, e.g., a Cu-to-Cu direct bonding, may be applied.

At least one of the first, second, and third interconnects 510, 520, and 530 may be different from the rest in arrangement of bumps for signal transmission and data lanes connected to the bumps. As an example, the first and second bumps 510bp and 520bp may be arranged with different pitches from each other.

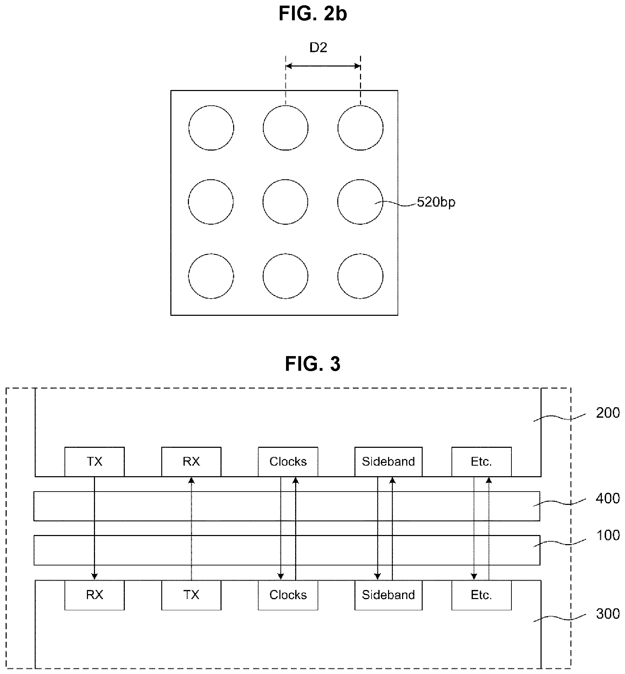

FIGS. 2A and 2B are plan views schematically illustrating the first bumps 510bp and the second bumps 520bp, respectively.

Referring to FIGS. 2A and 2B, each of the first bumps 510bp and the second bumps 520bp may be arranged in a two-dimensional matrix form. The arrangement of the first bumps 510bp and the second bumps 520bp should not be limited thereto or thereby, and the first bumps 510bp and the second bumps 520bp may be arranged in other forms rather than the two-dimensional matrix form. Hereinafter, the matrix form will be described as a representative example.

According to some example embodiments, the first bumps 510bp may have a different size from that of the second bumps 520bp and may be arranged at different pitches from the second bumps 520bp. According to some example embodiments, each of the second bumps 520bp may be greater than each of the first bumps 5 10bp. In addition, when assuming that the first bumps 5 10bp are arranged at the same pitch in a row and column direction and the second bumps 520bp are arranged at the same pitch in the row-column direction, the pitch between two first bumps 510bp adjacent to each other is referred to as a first pitch D1, and the pitch between two second bumps 520bp adjacent to each other is referred to as a second pitch D2. In this case, the second pitch D2 may be greater than the first pitch D1.

According to some example embodiments, the first pitch D1 between the first bumps 510bp may be within a range from about or exactly 10 micrometers to about or exactly 70 micrometers, for example, a range from about or exactly 25 micrometers to about or exactly 55 micrometers, and the second pitch D2 between the second bumps 520bp may be within a range from about or exactly 75 micrometers to about or exactly 200 micrometers, for example, a range from about or exactly 100 micrometers to about or exactly 130 micrometers. According to some example embodiments, the first and second bumps 510bp and 520bp may be selected from a variety of types of bumps. As an example, each of the first bumps 510bp may be a micro-bump including a metal pillar (e.g., a copper pillar) and a metal cap (e.g., SnAg), and each of the second bumps 520bp may be a C4 bump. However, the pitch and the type of the first and second bumps 5 10bp and 520bp should not be limited thereto or thereby and may be changed in various ways.

As described above, the first bumps 510bp may be arranged with the pitch different from the pitch of the second bumps 520bp, and thus, the number of the first bumps 5 10bp may be greater than the number of the second bumps 520bp in the same unit area. As shown in FIGS. 2A and 2B, for the same unit area, thirty-six first bumps 510bp may be arranged, and nine second bumps 520bp may be arranged.

As described above, the number of the first and second bumps 510bp and 520bp may be varied depending on a design rule of the semiconductor package, however, basically, the number of the second bumps 520bp is bound to be less than the number of the first bumps 510bp that are able to be used. Accordingly, when the signals from the data lanes connected to the first bumps 510bp are transmitted through the second bumps 520bp, it is important to determine a physical connection between the data lanes, that is, which data lanes among the data lanes of the first interconnect 510 are connected to which data lanes among the data lanes of the second interconnect 520.

FIG. 3 is a view schematically illustrating a signal transmission (a portion indicated by a double-headed arrow in FIG. 1A) between the first die 200 and the second die 300 in the semiconductor package according to some example embodiments of the present disclosure.

Referring to FIG. 3, the first die 200 and the second die 300 may include an interface for the signal transmission therebetween, and each of the first die 200 and the second die 300 may include the data lanes, clock lanes, sideband lanes, and various other lanes to bidirectionally or unidirectionally transmit various signals (clock signals, sideband signals, etc.) between a transmitter TX and a receiver RX. According to the present disclosure, various types of signals are transmitted through the interface between the first die 200 and the second die 300, and various type of lanes are used to transmit the various signals. For the convenience of explanation, various types of signals are collectively referred to as 'signals', and various types of lanes are collectively referred to as `data lanes. Some example embodiments of the present disclosure described below may be applied to various other signals and lanes to transmit them as long as they do not depart from the concepts of the present disclosure.

According to the present disclosure, the signals from the transmitter TX of the first die 200 may be transmitted to the receiver RX of the second die 300, and the signals from the transmitter TX of the second die 300 may be transmitted to the receiver RX of the first die 200. In this case, the first interconnect 510 and the second interconnect 520 may be provided between the first and second dies 200 and 300, and the signals may be transmitted from the first die 200 to the second die 300 and vice versa according to physical line connections within the first and second interconnects 510 and 520.

In this case, the signal transmission between the first die 200 and the second die 300 may be performed through the physical line connections. The number of data lanes connected to the first and second interconnects 510 and 520 may be determined depending on the arrangement and number of the first and second bumps 510bp and 520bp of the first and second interconnects 510 and 520, and the transmitted signals may be limited depending on the number of the data lanes.

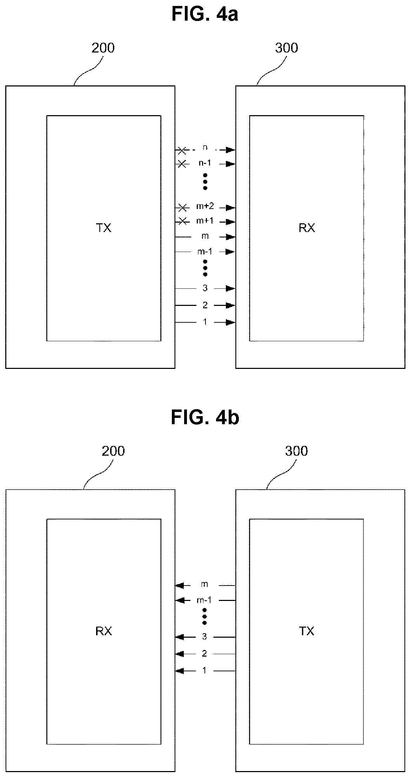

FIGS. 4A and 4B are views schematically illustrating the interface between the first die 200 and the second die 300 with the data lanes.

Referring to FIGS. 4A and 4B, the signals may be transmitted from the transmitter of the first die to the receiver of the second die and from the transmitter of the second die to the receiver of the first die, and each of the signals may be transmitted through its corresponding data lane.

However, as described above, whether the data lanes of the first and second dies are able to be used or not may be changed due to physical constraints caused by differences in pitch and number of the first and second bumps.

In more detail, in a case where the number of the first data lanes through which the first die 200 transmits signals is n and the number of the second data lanes through which the second die 300 transmits signals is m (m<n) when the signals are transmitted from the first die 200 to the second die 300, n-m (n minus m) data lanes among the data lanes may not be used (indicated by x) since the number of the data lanes of the receiver RX of the second die 300 is only m.

When the signals are transmitted from the second die 300 to the first die 200, the number of the data lanes through which the signals are transmitted from the transmitter TX of the second die 300 to the receiver RX of the first die 200 is only m and n-m data lanes among the data lanes may not be used since the number of the data lanes of the receiver RX of the first die 200 is n but the number of the data lanes of the transmitter of the second die 300 is only m.

However, when the first interconnect and the second interconnect are connected to each other through the vias of the interposer 400 or through the bridge lines of the package substrate, the first and second interconnects may be connected to each other only within a limit that is physically possible, and as a result, the order and/or position of the data lanes of the first interconnect may not correspond to the order and/or position of the data lanes of the second interconnect in the arrangement of the bumps. In particular, since the number of the data lanes of the first interconnect 510 is different from the number of the data lanes of the second interconnect 520, the number and positions of the data lanes of the first interconnect 510 that are possible to be physically connected to the data lanes of the second interconnect 520 may be further limited. Here, the expression "physically connected" means not only that two adjacent elements are directly and physically connected with each other in actual physical shapes, but also that two elements are connected to each other while at least one element with a different actual physical shape is interposed between the two elements.

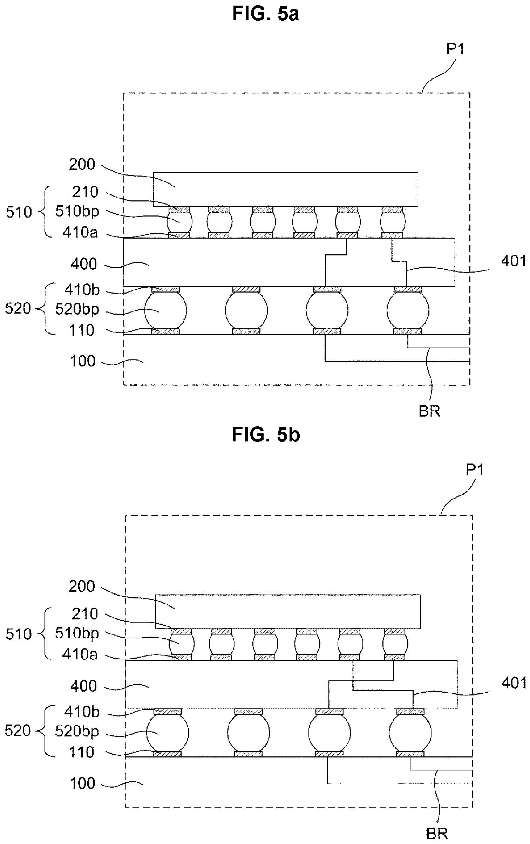

FIGS. 5A and 5B are views illustrating a physical connection relationship between the first bumps 510bp and the second bumps 520bp in the first and second interconnects 510 and 520 as a representative example. FIG. 5A illustrates a connection relationship that is physically possible, and FIG. 5B illustrates a connection relationship that is not physically possible. In this case, each of the first and second bumps 510bp and 520bp are actually connected two-dimensionally, but for the convenience of explanation, the following descriptions are made under the assumption that they are connected one-dimensionally in a cross section in the drawings.

Referring to FIG. 5A, the first interconnect 510 may be connected to the second interconnect 520 through the vias 401 with the interposer 400 interposed therebetween. In this case, the first bump 510bp that is located first from a right side may be connected to the second bump 520bp that is located first from the right side, and the first bump 510bp that is located second from the right side may be connected to the second bump 520bp that is located second from the right side. Accordingly, when the first interconnect 510 is connected to the second interconnect 520 through the vias 401, the vias 401 may not intersect each other, and thus, the first bumps 510bp may be electrically connected to the second bumps 520bp, respectively, without defects.

Referring to FIG. 5B, the first interconnect 510 may be connected to the second interconnect 520 through the vias 401 with the interposer 400 interposed therebetween. In this case, the first bump 510bp that is located first from the right side may be connected to the second bump 520bp that is located second from the right side, and the first bump 510bp that is located second from the right side may be connected to the second bump 520bp that is located first from the right side. However, in this case, the vias 401 may intersect each other, and as a result, the first bumps 510bp may not be electrically connected to the second bumps 520bp, respectively.

As the first bumps 510bp and the second bumps 520bp are arranged two-dimensionally, the number of connection cases between the first and second bumps 510bp and 520bp is more complex in the case where the first and second interconnects are connected to each other based on physical arrangement possibilities, that is, where the first and second bumps 510bp and 520bp are connected in a manner not dictated by proximity (see, e.g., FIG. 5A compared to FIG. 5B). Accordingly, the first bumps 510bp may be matched with the second bumps 520bp located at different positions in the matrix arrangement without being matched with the second bumps 520bp located at the same position in the matrix arrangement depending on the connection relationship of the vias 401 in the interposer 400, and bumps that are not matched may even exist according to the number of the first bumps 5 10bp and the number of the second bumps 520bp.

The connection relationship of the bumps between the second interconnect 520 and the third interconnect 530 in the package substrate 100 may also be limited according to the physical connection relationship described above. However, since the second interconnect 520 and the third interconnect 530 share the same interface (e.g., the second bumps 520bp) limitations in the number and position of the second bumps 520bp when connecting the second interconnect 520 and the third interconnect 530 may be less than the limitations in the number and position of the first and second bumps when connecting the first interconnect 510 and the second interconnect 520 or may not exist.

The semiconductor package of the present disclosure may include the remapping unit that selects the data lanes by taking into account the limitations in physical connection caused by the difference in the number of the bumps connected to the data lanes and remaps output signals to the selected data lanes when the signal transmission is performed between two dies, and thus, the above described defects and concerns caused by the limitations in physical connection may be solved or improved upon. For example, according to some example embodiments, there may be an increase in speed, accuracy, and/or power efficiency of chip to chip communication and operation of the device based on the above methods. Therefore, the improved devices and methods overcome the deficiencies of the conventional devices and methods of chiplet-type semiconductor packages related to including different types of semiconductor packages while reducing resource consumption and increasing data clarity. Further, there is a size and/or compactness improvement by providing the ability for different types of semiconductor packages to communicate on a chiplet-type semiconductor package as discussed herein.

In detail, in a case where the number of the data lanes of the transmitter and/or the receiver of the first die 200 is different from the number of the data lanes of the transmitter and/or the receiver of the second die 300, the remapping unit may allow the signals input to an initial transmitter, which transmits/receives the signals to and from the first and second bumps 510bp and 520bp, to be output to the receiver as they are.

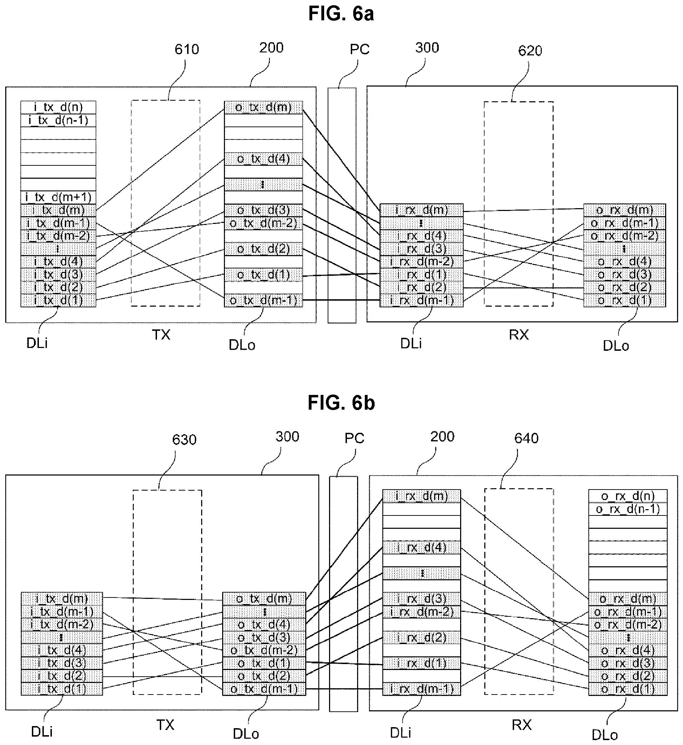

FIGS. 6A and 6B are views schematically illustrating a signal transmission process from the first die 200 to the second die 300 or from the second die 300 to the first die 200 in the semiconductor package according to some example embodiments of the present disclosure and illustrate a sequential arrangement of the data lanes. FIG. 6A illustrates the arrangement of the data lanes when the signals are transmitted from the first die 200 to the second die 300, and FIG. 6B illustrates the arrangement of the data lanes when the signals are transmitted from the second die 300 to the first die 200.

Referring to FIGS. 6A and 6B, the first die 200 and the second die 300 may respectively include the transmitter TX and the receiver RX for the signal transmission.

The transmitter TX of the first die 200 may include input data lanes DLi where signals to be transmitted are input, output data lanes DLo where signals to be transmitted are output, and a first remapping unit 610 remapping the signals from the input data lanes DLi and providing the remapped signals to the output data lanes DLo selected based on predetermined (or, alternatively, desired or selected) criteria. The first remapping unit 610 may select and match the output data lanes DLo with the input data lanes DLi in an order different from an order of the signals input to the input data lanes DLi. In a case where the order of the input data lanes DLi to which the signals are input and the order of the signals corresponding to the input data lanes DLi is referred to as a first order, the order of the selected output data lanes DLo and the order of the signals corresponding to the selected output data lanes DLo is referred to as a second order different from the first order. In this case, the second order of the output data lanes DLo may be determined depending on the physical connection relationship between the first interconnect and the second interconnect, e.g., between the first bumps and the second bumps and may be different from the first order.

For example, according to some example embodiments of the present disclosure, in a case where the first die 200 includes n data lanes, the number of data lanes used to transmit the signals may be set to m, which is smaller than n. This is because the number of the data lanes of the receiver RX of the second die 300 is smaller than the number of the data lanes of the transmitter TX of the first die 200, and thus, the number of the data lanes used may be equal to or smaller than the number of the data lanes of the second die 300. That is, the number of the data lanes where the signals are input in the first die 200 may be equal to or smaller than the number of the second bumps.

In some example embodiments, in a case where the data lanes arranged sequentially from a bottom to a top are respectively referred to as a first data lane, a second data lane, a third data lane, a fourth data lane, ..., an (m-2)th data lane, an (m-1)th data lane, an m-th data lane, ..., an (n-1)th data lane, and an n-th data lane, the first remapping unit 610 may select only some data lanes (the first data lane, the second data lane, the third data lane, the fourth data lane, ..., the (m-2)th data lane, the (m-1)th data lane, and the m-th data lane) to transmit the signals to the second die 300 among the data lanes (the first data lane, the second data lane, the third data lane, the fourth data lane, ..., the (m-2)th data lane, the (m-1)th data lane, the m-th data lane, ..., the (n-1)th data lane, and the n-th data lanes) and may output corresponding signals to the selected data lanes to the corresponding data lanes.

In this case, the selection of the data lanes by the first remapping unit 610 may be made from those available for the physical connection by taking into account the physical connection relationship between the first bumps and the second bumps. Among the data lanes, data lanes that are not able to connect the first bumps and the second bumps may not be selected. In FIGS. 6A and 6B, the data lanes selected from those available for the physical connection are displayed as a halftone dot pattern.

Accordingly, the input data lanes DLi to which the signals are initially assigned and the output data lanes DLo selected and remapped by the first remapping unit 610 may be arranged in different orders. As an example, in the case where the first data lane to the n-th data lane of the input data lanes DLi are assigned with i_tx_d(1) to i_tx_d(n), the first data lane to the m-th data lane i_tx_d(1) to i_tx_d(m) may be selected and remapped by the first remapping unit 610. Therefore, the output data lanes DLo may be arranged in the order different from that of the input data lanes DLi as shown in figures. The selected data lanes may output the signals to the second die 300 through the physical connection between the first and second interconnects.

The receiver RX of the second die 300 may include input data lanes DLi where the signals to be received are input, output data lanes DLo where the received signals are output, and a second remapping unit 620 remapping the signals of the input data lanes DLi and providing the remapped signals to the output data lanes DLo selected based on predetermined (or, alternatively, desired or selected) criteria.

The second remapping unit 620 may select and match the output data lanes DLo with the input data lanes DLi in an order different from an order of the signals input to the input data lanes DLi. The second remapping unit 620 may operate in substantially the same or the same way as the first remapping unit 610. In a case where the order of the input data lanes DLi to which the signals are input or the order of the signals corresponding to the input data lanes DLi is referred to as a third order, the third order may be determined based on the physical connection relationship between the first bumps and the second bumps and may be different from the second order. Then, the second remapping unit 620 may set the order of the selected output data lanes DLo and the order of the signals corresponding to the selected output data lanes DLo to be the first order that is different from the third order.

Similarly, referring to FIG. 6B, each of the second die 300 and the first die 200 may include the transmitter TX and the receiver RX for the signal transmission.

The signal transmission from the second die 300 to the first die 200 may be performed in substantially the same or the same manner as described above with reference to FIG. 6A.

The transmitter TX of the second die 300 may include input data lanes DLi where signals to be transmitted are input, output data lanes DLo where signals to be transmitted are output, and a third remapping unit 630 remapping the signals of the input data lanes DLi and providing the remapped signals to the output data lanes DLo selected based on predetermined (or, alternatively, desired or selected) criteria. The third remapping unit 630 may select and match the output data lanes DLo with the input data lanes DLi in an order different from the order of the signals input to the input data lanes DLi.

In this case, the order of the output data lanes DLo may be determined depending on the physical connection relationship between the first interconnect and the second interconnect, e.g., between the first bumps and the second bumps.

The receiver RX of the first die 200 may include input data lanes DLi where signals to be received are input, output data lanes DLo where the received signals are output, and a fourth remapping unit 640 remapping the signals of the input data lanes DLi and providing the remapped signals to the output data lanes DLo selected based on predetermined (or, alternatively, desired or selected) criteria. The fourth remapping unit 640 may output the signals input to the input data lanes DLi in an order that matches with the order in which the signals are initially transmitted.

According to the present disclosure, the input data lanes DLi of the transmitter TX may exist as a physical component, however, the present disclosure should not be limited thereto or thereby. That is, the input data lanes DLi of the transmitter TX may not exist as the physical component. The output data lanes DLo of the receiver RX may or may not exist as a physical component. In contrast, the output data lanes DLo of the transmitter TX and the input data lanes DLi of the receiver RX may exist as the physical component and may be physically connected to each other. Accordingly, the signals output to the first bumps connected to the selected data lanes may be transmitted to the second bumps physically connected to the first bumps through the vias of the interposer and/or the bridge line of the package substrate. Since the connection lines (for example, the vias and/or the bridge line of the package substrate) between the first bumps and the second bumps are physically connected to other components, the connection relationship of the connection lines may not be changed, and the connection relation may be substantially fixed or completely fixed (not changeable).

As described above, in a case where the transmission signal initially input is output to the second die 300 as it is without remapping the transmission signal even though the connection relationship between the transmitter TX of the first die 200 and the receiver RX of the second die 300 through the first and second bumps is determined by the physical connection PC between the first bumps and second bumps, signals assigned to the data lanes that are not physically connected are not able to be transmitted. In addition, even though the signals are assigned to the data lanes that are physically connected, the signals may be applied to other lanes instead of the lanes corresponding thereto.

According to the present disclosure, the second remapping unit 620 may select and remap non-matched data lanes in consideration of the physical connection between the first bumps and the second bumps and may output signals of the data lanes finally determined. In this way, the signals initially input may be transmitted from the first die 200 to the second die 300 through the remapping of the signals by the first remapping unit 610 and the second remapping unit 620.

According to some example embodiments, in the case where the second die 300 includes m data lanes and the data lanes sequentially arranged from the bottom to the top are respectively referred to as the first data lane, the second data lane, the third data lane, the fourth data lane, ..., the (m-2)th data lane, the (m-1)th data lane, and the m-th data lane, the third remapping unit may select the data lanes, which enable the physical connection, to transmit the signals to the first die 200 among the data lanes (e.g., the first data lane, the second data lane, the third data lane, the fourth data lane, ..., the (m-2)th data lane, the (m-1)th data lane, and the m-th data lane) in consideration of the physical connection relationship between the second bumps and the first bumps and may remap the signals applied to the selected data lanes.

Accordingly, the data lanes to which the signals are initially assigned and input and the data lanes selected by the third remapping unit are arranged in different orders from each other based on an order in which the same signals are applied. The selected data lanes may be connected to different second bumps from each other and the signals may be output to the first die 200 through different second bumps from each other.

The signals whose order is changed may be output through the corresponding second bumps and may be transmitted to the first bumps physically connected to the second bumps through the vias 401 of the interposer 400 and/or the bridge line of the package substrate 100. Since the connection line between the second bumps and the first bumps (for example, the vias 401 and/or the bridge line of the package substrate 100) are physically connected, the connection relationship of the lines may not be changed and may be substantially fixed or completely fixed (not changeable).

Since the connection relationship through the first bumps of the receiver RX of the first die 200 is determined the physical connection between the first bumps and the second bumps, only some data lanes selected from the data lanes of the receiver RX of the first die 200 may correspond to the data lanes transmitting the signals. Accordingly, the order or corresponding data lanes of the signals transmitted through the selected data lanes may not match the order or corresponding data lanes of the initially input transmission signals. The fourth remapping unit may select and remap non-matched data lanes and may output the signals of the finally determined data lanes in consideration of the physical connection between the second bumps and the first bumps.

As described above, since the connection relationship between the transmitter TX of the second die 300 and the receiver RX of the first die 200 through the second and first bumps is determined by the physical connection between the first bumps and the second bumps, the third and fourth remapping units according to the present disclosure may select and remap non-matched data lanes and may output the signals of the finally determined data lanes in consideration of the physical connection between the first bumps and the second bumps. In this way, the signals initially input may be transmitted from the second die 300 to the first die 200 in the same order.

According to a conventional semiconductor package, an interface for a transmission of signals between two dies is limited to a structure in which the two dies include the same number of data lanes and bumps connected to the data lanes. This is because the physical connection is difficult when the types of bumps of the two dies are different from each other, for example, when the pitches of the bumps adjacent to each other or the number of the bumps are different from each other.

According to the semiconductor package of the present disclosure, the signals are remapped and assigned to the bumps, respectively, by taking into account the physical connection relationship through logical operations with the limitations in physical connection at present, that is, without changing the physical connection relationship, and thus, the signals may be transmitted between two dies having different types of bumps.

In some example embodiments, the first die 200 and the second die 300 provided with the interposer 400 interposed therebetween are described as a representative example, however, the present disclosure may be applied to any case where there is a difficulty in arranging the data lanes to be used due to physical differences between the bumps of the interconnect or due to limitations in the physical connection relationship of the lines connecting the dies. Particularly, according to the semiconductor package of the present disclosure, the signals may be transmitted between a 2.5D type die and a 2D type die.

In particular, according to the present disclosure, high-cost devices with difficult and complex manufacturing processes and low-cost devices with simple manufacturing processes may be placed separately from each other on the interposer or the package substrate, and thus, it is possible to reduce the cost of manufacturing the semiconductor package.

According to some example embodiments of the present disclosure, the number of the data lanes selected from the transmitter TX or the receiver RX in the first die 200 or the second die 300 may be greater than that of the above-described embodiment. This is because the data lanes may transmit various signals in addition to the signal transmission using the transmitter TX and the receiver RX and additional data lanes may be provided for the transmission of the various signals. Accordingly, the number of the data lanes of the transmitter TX and the receiver RX after the remapping process may be greater than the number of the data lanes of the transmitter TX and the receiver RX before the remapping process. In this case, the first remapping unit 610 and the second remapping unit 620 may select valid data lanes from among a larger number of data lanes.

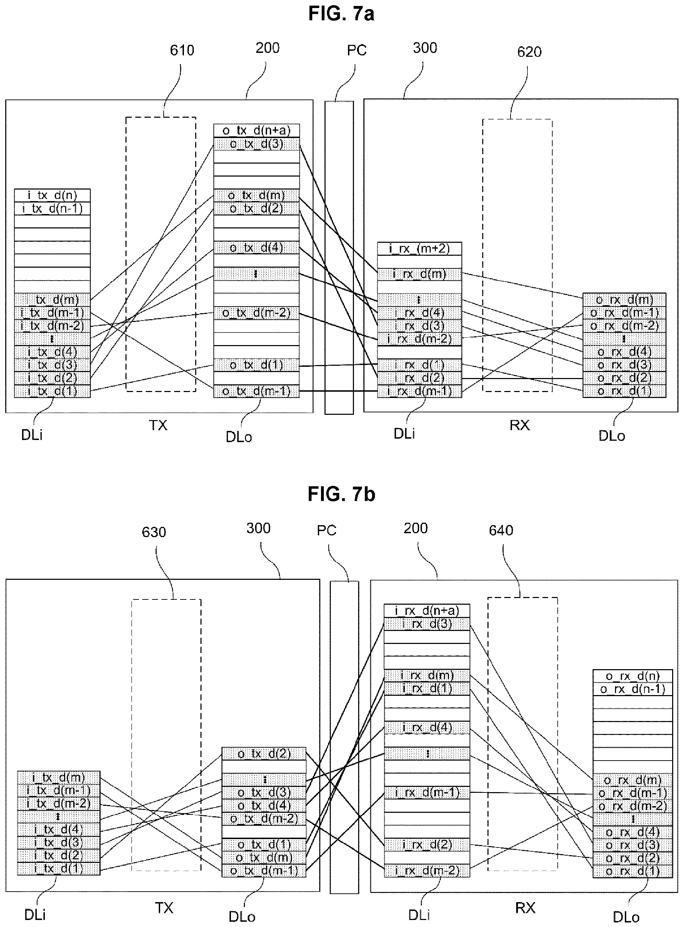

FIGS. 7A and 7B are views schematically illustrating a signal transmission process from a first die 200 to a second die 300 or from the second die 300 to the first die 200 in a semiconductor package according to some example embodiments of the present disclosure. FIG. 7A illustrates the signal transmission from the first die 200 to the second die 300, and FIG. 7B illustrates the signal transmission from the second die 300 to the first die 200. In FIGS. 7A and 7B, the number of data lanes of a transmitter TX of the first die 200 and the number of data lanes of a receiver RX of the second die 300 are different from those of the semiconductor package described with reference to FIGS. 6A and 6B.

Hereinafter, descriptions will be focused on different features from those of the semiconductor package described with reference to FIGS. 6A and 6B in order to avoid redundancy.

Referring to FIG. 7A, the signals to be transmitted from the first die 200 to the second die 300 may be selected in the first die 200 and may be assigned to the data lanes to be transmitted, and in the transmitter TX of the first die 200, the number of output data lanes DLo may be greater than the number of input data lanes DLi. As an example, when the number of the input data lanes DLi required for the signals to be transmitted is n, the number of the output data lanes DLo of the transmitter TX may be n+a. In this case, as with the above-described embodiment, when the number of the data lanes required for the signals to be transmitted is set to m in some example embodiments, a remapping unit may select m data lanes from the n+a data lanes and may output the signals to first bumps.

The signals (a first signal, a second signal, a third signal, a fourth signal, ..., an (m-2)th signal, an (m-1)th signal, and an m-th signal) output to the first bumps may be transmitted to second bumps through a physical connection PC, such as vias 401 of an interposer 400 and/or a bridge line of a package substrate 100.

In the case where the number of input data lanes required for the signals to be received is m in the receiver RX of the second die 300, the number of input data lanes DLi of the receiver RX may be m+b. FIG. 7A shows that two more data lanes are added (e.g., b=2).

A second remapping unit 620 may select and remap non-matched data lanes by taking into account the physical connection PC between first and second interconnects and may output remapped signals.

In this way, the signals initially input may be transmitted from the first die 200 to the second die 300 through the remapping of the signals by a first remapping unit 610 and the second remapping unit 620.

Referring to FIG. 7B, the second die 300 may include second bumps connected to m+b data lanes and a third remapping unit 630 remapping signals input to the data lanes and outputting the remapped signals. The first die 200 may include first bumps connected to n+a data lanes and a fourth remapping unit 630 remapping signals received to the first bumps and outputting the remapped signals.

The signals transmitted from the second die 300 to the first die 200 may be transmitted through substantially the same or the same path as the signals transmitted from the first die 200 to the second die 300.

According to some example embodiments of the present disclosure, the second remapping unit or the third remapping unit may be omitted in a case where the data lanes that match with the data lanes corresponding to the first bumps and the data lanes of the signals to be transmitted are obtained in the receiver of the second die through the physical connection relationship between the first bumps and the second bumps.

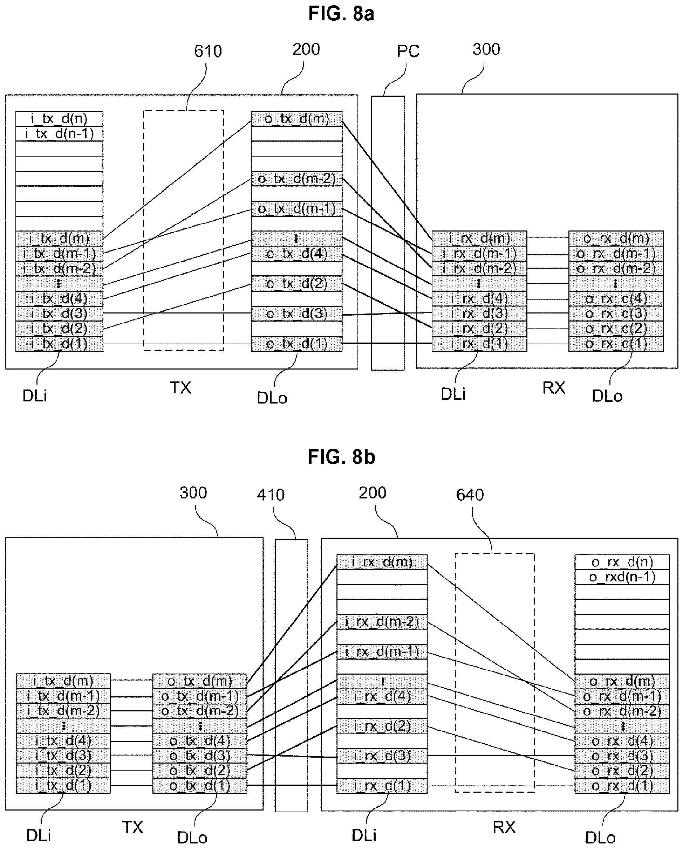

FIGS. 8A and 8B are views schematically illustrating a signal transmission process from a first die 200 to a second die 300 or from the second die 300 to the first die 200 in a semiconductor package according to some example embodiments of the present disclosure.

Referring to FIG. 8A, the first die 200 may include a first remapping unit 610 that remaps signals input to n data lanes and outputs the remapped signals to the second die 300. The first remapping unit 610 may select m data lanes among the n data lanes and may output the remapped signals to first bumps. The first remapping unit 610 may select the data lanes among the data lanes that are able to be physically connected by taking into account the physical connection relationship between first and second interconnects. In a case where the output result obtained by the selection of the data lanes by the first remapping unit 610 is the same as the signal transmission through initial data lanes in a receiver RX of the second die 300, a second remapping unit may be omitted. Accordingly, the signals provided to input data lanes DLi of the receiver RX of the second die 300 may be output directly to output data lanes DLo without remapping.

Referring to FIG. 8B, in a case where the same output result as the signal transmission through initial data lanes in a receiver RX of the first die 200 is obtained by taking into account the physical connection relationship between second bumps and first bumps and the remapping result by the first remapping unit 610 of the first die 200, a third remapping unit may be omitted. Accordingly, the signals received in the input data lanes DLi of the receiver RX of the first die 200 may be immediately output to output data lanes DLo without remapping.

In the above-described embodiments, the semiconductor package includes the first and second dies, however, the present disclosure should not be limited thereto or thereby, and the semiconductor package may include three or more dies. As an example, the semiconductor package may further include an additional die provided on the interposer and/or the package substrate and connected to at least one of the first and second dies through the interconnect.

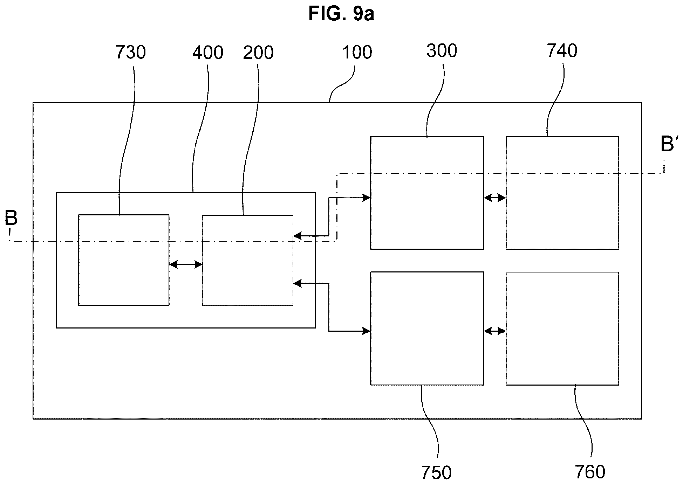

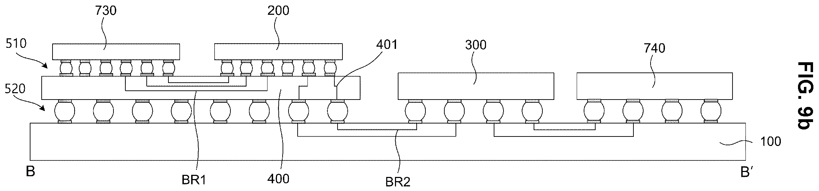

FIG. 9A is a view illustrating a semiconductor package in which six dies are provided on a package substrate according to some example embodiments of the present disclosure, and FIG. 9B is a cross-sectional view taken along a line B-B' of FIG. 9A.

Referring to FIGS. 9A and 9B, the semiconductor package may include the package substrate 100, an interposer 400, and first, second, third, fourth, fifth, and sixth dies 200, 300, 730, 740, 750, and 760.

The first die 200 and the third die 730 may be disposed on the package substrate 100 with the interposer 400 interposed therebetween, and the second die 300, the fourth die 740, the fifth die 750, and the sixth die 760 may be disposed directly on the package substrate 100.

As the first, second, third, fourth, fifth, and sixth dies 200, 300, 730, 740, 750, and 760 are connected to each other in various forms, signals may be transmitted therebetween. As an example, the first die 200 and the third die 730 disposed on the interposer 400 may be connected to each other, the second die 300 and the fourth die 740 may be connected to each other on the package substrate 100, and the fifth die 750 and the sixth die 760 may be connected to each other on the package substrate 100. In addition, the first die 200 disposed on the interposer 400 may be connected to the second die 300 disposed on the package substrate 100, and the first die 200 disposed on the interposer 400 may be connected to the fifth die 750 disposed on the package substrate 100.

In some example embodiments, the first die 200 and the second die 300 may be connected to each other with the interposer 400 interposed therebetween, and the first die 200 and the second die 300 may be connected to the interposer 400 through different bumps from each other. The first die 200 and the fifth die 750 may be connected to each other with the interposer 400 interposed therebetween, and the first die 200 and the fifth die 750 may be connected to the interposer 400 through different bumps from each other. In detail, the first die 200 and the interposer 400 may be connected to each other by a first interconnect 510, and the third die 730 and the interposer 400 may be connected to each other by the first interconnect 510 including the first bumps 510bp. The interposer 400 and the package substrate 100 may be connected to each other by a second interconnect 520, and the package substrate 100 and the second die 300 may be connected to each other by the second interconnect 520 including the second bumps 520bp.

Accordingly, the data lanes that are able to be actually connected may be limited depending on the vias 401 of the interposer 400 and connection relationship between the bumps with different pitches, and in this case, the data lanes may be selected by a remapping unit. Therefore, the signals may be mutually transmitted between the first die 200 and the second die 300.

Since the first die 200 and the third die 730 disposed on the interposer 400 are connected to each other via a first bridge line BR1 in the interposer 400 and use the same type of data lanes and bumps corresponding to the same type of data lanes, the remapping of the data lanes may not be necessary. The second die 300 and the fourth die 740 disposed on the package substrate 100 may be connected to each other through a second bridge line BR2 and may use the same type of data lanes and bumps corresponding to the same type of data lanes, the fifth die 750 and the sixth die 760 disposed on the package substrate 100 may be connected to each other through the second bridge line BR2 and may use the same type of data lanes and bumps corresponding to the same type of data lanes, and thus, the remapping of the data lanes may not be necessary. In this case, the first bridge line BR1 may be configured to include lines within the interposer 400, however, it should not be limited thereto or thereby. According to some example embodiments, the first bridge line BR1 may include a separate silicon bridge and may be embedded in the interposer 400. The second bridge line BR2 may also be configured to include lines within the package substrate 100, however, it should not be limited thereto or thereby. According to some example embodiments, the second bridge line BR2 may include a separate silicon bridge and may be embedded in the interposer 400.

According to some example embodiments of the present disclosure, when the die is provided in plural, the communication between the dies may be implemented in various forms and should not be limited to the above-described embodiments. As an example, the third die 730 and the second die 300 may communicate with each other, however, according to some example embodiments, the third die 730 may be connected to and communicate with the fifth die 750.

In some example embodiments, the first die 200 and the third die 730 may be IC (integrated circuit) devices with the same or similar functions or may be IC devices with different functions. The second die 300 and the fourth to sixth dies 740 to 760 may be IC devices with the same or similar functions or may be IC devices with different functions.

In some example embodiments of the present disclosure, the semiconductor package with a hybrid interconnect may have various types of 2D and/or 2.5D structures when including multiple dies. As an example, the semiconductor package with the hybrid interconnect may include TSMC's Chip-on-Wafer-on-Substrate (CoWoS), Cadence's High Bandwidth Interconnect (HBI), Intel's Universal Chiplet Interconnect Express (UCIe), Samsung's High Bandwidth Bridge (HBB), etc. When different types of interconnects described above are used, the selecting of the data lanes may be difficult due to limitations in physical connection, and in this case, the remapping unit according to some example embodiments of the present disclosure may be adopted. In particular, when it is difficult to select the data lanes due to the use of different types of interconnects, the remapping unit according to some example embodiments of the present disclosure may be adopted even though the semiconductor package does not have the 2.5D structure including the interposer 400.

According to some example embodiments of the present disclosure, some of the dies connected to the semiconductor package may be a 3D IC device. The 3D IC device may be a package-on-package (PoP) device using a connection method such as a wire bonding or a flip chip, and particularly, the 3D IC device may be a system-in-package (SiP) sequentially stacked or a wafer level package (WLP) sequentially stacked.

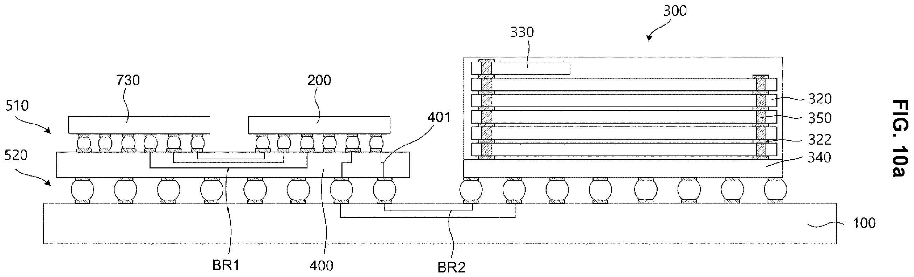

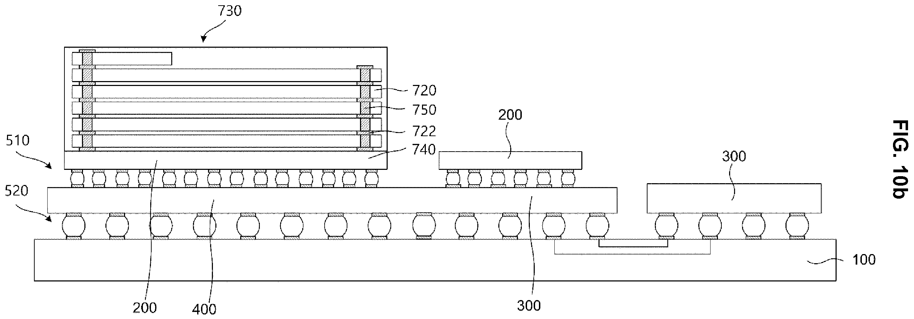

FIGS. 10A and 10B are views illustrating a semiconductor package according to some example embodiments of the present disclosure, and some of dies on an interposer are 3D devices stacked three-dimensionally.

Referring to FIGS. 10A and 10B, the semiconductor package may include a first die 200, a second die 300, and a third die 730. The first die 200 and the third die 730 may be disposed on the interposer 400, and the second die 300 may be disposed on the package substrate 100.

The second die 300 of FIG. 10A and the third die 730 of FIG. 10B may be a 3D semiconductor device. As an example, the 3D semiconductor device may be a memory device having a structure in which five semiconductor chips 320 are vertically stacked on a logic substrate 340 or five semiconductor chips 720 and a memory control chip are vertically stacked on a logic substrate 740. In some example embodiments, the five semiconductor chips are vertically stacked, however, the number and the stack direction of each of the semiconductor chips 320 and 720 should not be limited thereto or thereby. The number of each of the semiconductor chips 320 and 720 may be less or more than five as needed. The semiconductor chips 320 and 720 may be respectively arranged on the logic substrates 340 and 740 along a horizontal direction or may be arranged in a connection structure obtained by combining the vertical mount and the horizontal mount. In some example embodiments, memory control chip 330 may be omitted. The semiconductor chips 320 and 720 may include via structures 322 and 722, respectively, and the via structures 322 and 722 may be electrically connected by interconnects, for example, bumps. In some example embodiments, the via structures 332 and 732 may be omitted from the memory control chips 330 and 730.

Each of the semiconductor chips 320 and 720 may include a system LSI, a flash memory, a DRAM, an SRAM, an EEPROM, a PRAM, an MRAM, or an RRAM. The memory control chip 330 may include logic circuit, for example, SerDes (Serializer/Deserializer) circuit.

The semiconductor package of the present disclosure may be applied or employed in a wide range of electronic systems.

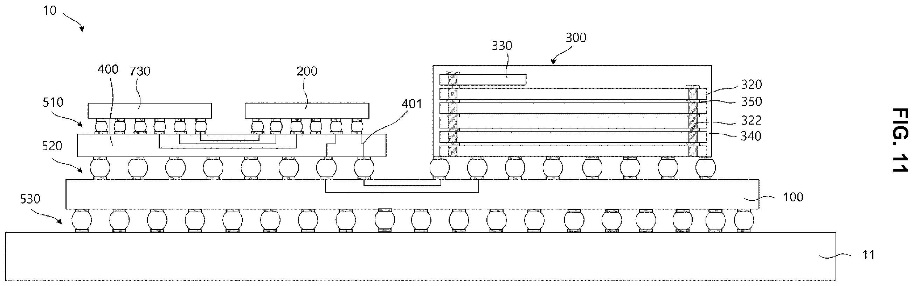

FIG. 11 is a cross-sectional view illustrating an electronic system employing the semiconductor package according to some example embodiments of the present disclosure. In some example embodiments, the electronic system employing the semiconductor package of FIG. 10A will be described as a representative example.

Referring to FIG. 11, the electronic system 10 may include a main board 11 and the semiconductor package mounted on the main board 11.

The third interconnect 530 may be provided between the main board 11 and the semiconductor package. The third interconnect 530 may be an interconnect with substantially the same or the same type of bumps as the second interconnect 520 or may be an interconnect with different type of bumps from the first and second interconnects 510 and 520.

In FIG. 11, the electronic system is schematically shown, however, various electronic elements including the semiconductor package according to some example embodiments of the present disclosure may be arranged on the above-described main board 11. As an example, the electronic system may be physically and/or electrically connected to network components or other components in addition to the semiconductor package described above.

The semiconductor package according to some example embodiments of the present disclosure may include various logic semiconductor devices and memory semiconductor devices and may further include other types of related components. The network components may include IEEE 802.11 family (Wi-Fi), IEEE 802.16 family (WiMAX), IEEE 802.20, long term evolution (LTE), Ev-DO, HSPA+, HSDPA+, HSUPA+, EDGE, GSM, GPS, GPRS, CDMA, TDMA, DECT, Bluetooth, 3G, 4G, 5G, and any other wireless and wired protocols designated thereafter, however, it should not be limited thereto or thereby. According to some example embodiments, the network components may include any of a plurality of wireless or wired standards or protocols. In addition, network-related components may be combined in various ways with the semiconductor package.

As other components, a high-frequency inductor, a ferrite inductor, a power inductor, a ferrite bead, a low temperature co-firing ceramics (LTCC), an electro-magnetic interference (EMI) filter, a multi-layer ceramic condenser (MLCC), etc., may be included, however, the present disclosure should not be limited thereto or thereby. According to some example embodiments, passive components used for various other purposes may be further included. These other components may also be combined in various ways with the semiconductor package and the network-related components described above.

In addition, the electronic system may include other components that may or may not be physically and/or electrically connected to a mother board depending on its type. As the other components, a camera, an antenna, a display, a battery, an audio codec, a video codec, a power amplifier, a compass, an accelerometer, a gyroscope, a speaker, and a mass storage device (such as hard disk drive, compact disk (CD), digital versatile disk (DVD), and so forth) may be employed, however, they should not be limited thereto or thereby. In addition, other components used for various purposes may be included depending on the type of electronic device.

The electronic system may be a smart phone, a personal digital assistant, a digital video camera, a digital still camera, a network system, a computer, a monitor, a tablet computer, a laptop computer, a netbook computer, a television set, a video game, a smart watch, an automotive part, etc.

However, the present disclosure should not be limited thereto or thereby, and in addition to those described above, the electronic system may be any other electronic device that processes data.

Although some example embodiments of the present disclosure have been described, it is understood that the present disclosure should not be limited to these example embodiments but various changes and modifications can be made by one ordinary skilled in the art within the scope of the present disclosure as hereinafter claimed.

When the terms "about" or "substantially" are used in this specification in connection with a numerical value, it is intended that the associated numerical value includes a manufacturing or operational tolerance (e.g., ±10 %) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10 %) around the stated numerical values or shapes.

As described herein, any electronic devices and/or portions thereof according to any of the example embodiments may include, may be included in, and/or may be implemented by one or more instances of processing circuitry such as hardware including logic circuits; a hardware/software combination such as a processor executing software; or any combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a DRAM device, storing a program of instructions, and a processor (e.g., CPU) configured to execute the program of instructions to implement the functionality and/or methods performed by some or all of any devices, systems, modules, units, controllers, circuits, architectures, and/or portions thereof according to any of the example embodiments, and/or any portions thereof.

Therefore, the disclosed subject matter should not be limited to any single embodiment described herein, and the scope of the present inventive concepts shall be determined according to the attached claims.

### ANNEX A

The present invention can also be defined by reference to the following clauses:
Clause 1. A semiconductor package comprising first and second dies that transmit and/or receive signals with each other, comprising:
   a package substrate;
   at least one the first die on the package substrate and connected to the package substrate with an interposer therebetween; and
   at least one the second die on the package substrate and connected to the package substrate, each of the first and second dies comprising a transmitter and a receiver, each comprising data lanes, and a number of the data lanes of the transmitter and/or the receiver of the first die is different from a number of the data lanes of the transmitter and/or the receiver of the second die.
Clause 2. The semiconductor package of clause 1, further comprising:
   first bumps connected to the data lanes corresponding to the transmitter and the receiver of the first die; and
   second bumps connected to the data lanes corresponding to the transmitter and the receiver of the second die.
Clause 3. The semiconductor package of clause 2, wherein the first bumps have a pitch different from a pitch of the second bumps.
Clause 4. The semiconductor package of clause 3, wherein the first bumps are between the first die and the interposer, and the second bumps are between the second die and the package substrate and between the package substrate and the interposer.
Clause 5. The semiconductor package of clause 4, wherein the interposer comprises a plurality of vias through which the first bumps are connected to the second bumps.
Clause 6. The semiconductor package of any of clauses 3 to 5, wherein the number of the data lanes of the second die is smaller than the number of the data lanes of the first die.
Clause 7. The semiconductor package of any preceding clause, further comprising a remapping unit configured to remap the signals input thereto in a different order from an input order of the signals and output the remapped signals to corresponding data lanes, respectively, in response to the signals being transmitted between the data lanes of the first die and the data lanes of the second die.
Clause 8. The semiconductor package of clause 7, wherein the transmitter and/or the receiver of each of the first and second dies comprises:
   input data lanes configured to receive signals;
   the remapping unit configured to remap and provide the signals of the input data lanes to output data lanes; and
   the output data lanes configured to receive the remapped signals from the remapping unit and output the remapped signals.
Clause 9. The semiconductor package of clause 8, wherein the remapping unit is provided to each of the transmitter and the receiver of the first die.
Clause 10. The semiconductor package of clause 8 or clause 9, wherein the remapping unit comprises:
   first and second remapping units respectively provided to the transmitter and the receiver of the first die; and
   third and fourth remapping units respectively provided to the transmitter and the receiver of the second die.
Clause 11. The semiconductor package of clause 10, wherein the output data lanes of the transmitter of the first die are physically connected to the input data lanes of the receiver of the second die.
Clause 12. The semiconductor package of clause 11, wherein the remapping unit is configured to select the data lanes physically connected to the input data lanes of the receiver of the second die among the output data lanes of the transmitter of the first die and provide the signals.
Clause 13. The semiconductor package of any preceding clause, further comprising at least one third die on the interposer and/or the package substrate and connected to at least one of the first and second dies.
Clause 14. The semiconductor package of any preceding clause, wherein each of the first die and/or the second die comprises at least one of a logic semiconductor device or a memory semiconductor device.
Clause 15. The semiconductor package of any preceding clause, wherein the at least one first die is connected to the package substrate by a first interconnect; and
   the at least one second die is connected to the package substrate by a second interconnect,
   the first interconnect comprising first bumps arranged at a first pitch, the second interconnect comprises second bumps arranged at a second pitch different from the first pitch, and
   at least one of the first and second dies comprising a remapping unit configured to allocate signals arranged in a first order to the first bumps of the first interconnect and/or the second bumps of the second interconnect in a second order different from the first order.

## Claims

1. A semiconductor package comprising:
first and second dies that transmit and/or receive signals with each other;
a package substrate; and
an interposer, wherein:
the first die is on the package substrate and connected to the package substrate with the interposer therebetween; and
the second die is on the package substrate and connected to the package substrate,
each of the first and second dies comprising a transmitter and a receiver, each comprising data lanes, and a number of the data lanes of the transmitter and/or the receiver of the first die is different from a number of the data lanes of the transmitter and/or the receiver of the second die.

2. The semiconductor package of claim 1, further comprising:
first bumps connected to the data lanes corresponding to the transmitter and the receiver of the first die; and
second bumps connected to the data lanes corresponding to the transmitter and the receiver of the second die.

3. The semiconductor package of claim 2, wherein the first bumps have a pitch different from a pitch of the second bumps.

4. The semiconductor package of claim 3, wherein the first bumps are between the first die and the interposer, and the second bumps are between the second die and the package substrate and between the package substrate and the interposer.

5. The semiconductor package of claim 4, wherein the interposer comprises a plurality of vias through which the first bumps are connected to the second bumps.

6. The semiconductor package of any of claims 3 to 5, wherein the number of the data lanes of the second die is smaller than the number of the data lanes of the first die.

7. The semiconductor package of any preceding claim, further comprising at least one remapping unit configured to remap the signals input thereto in a different order from an input order of the signals and output the remapped signals to corresponding data lanes, respectively, in response to the signals being transmitted between the data lanes of the first die and the data lanes of the second die.

8. The semiconductor package of claim 7, wherein the at least one remapping unit comprises a plurality of remapping units wherein the transmitter and/or the receiver of each of the first and second dies comprises:
input data lanes of the data lanes belonging to the respective die, the input data lanes configured to receive signals; and
one of the remapping units configured to remap and provide the signals of the input data lanes to output data lanes of the data lanes belonging to the respective die, the output data lanes being configured to receive the remapped signals from the respective ones of the remapping units and output the remapped signals.

9. The semiconductor package of claim 8, wherein each of the transmitter and the receiver of the first die comprises one of the remapping units.

10. The semiconductor package of claim 8 or claim 9, wherein the at least one remapping unit comprises:
first and second remapping units respectively provided to the transmitter and the receiver of the first die; and
third and fourth remapping units respectively provided to the transmitter and the receiver of the second die.

11. The semiconductor package of claim 10, wherein the output data lanes of the transmitter of the first die are physically connected to the input data lanes of the receiver of the second die.

12. The semiconductor package of claim 11, wherein the at least one remapping unit is configured to select the data lanes physically connected to the input data lanes of the receiver of the second die among the output data lanes of the transmitter of the first die and provide the signals.

13. The semiconductor package of any preceding claim, further comprising at least one third die on the interposer and/or the package substrate and connected to at least one of the first and second dies.

14. The semiconductor package of any preceding claim, wherein each of the first die and/or the second die comprises at least one of a logic semiconductor device or a memory semiconductor device.

15. The semiconductor package of any preceding claim, wherein the first die is connected to the package substrate by a first interconnect; and
the second die is connected to the package substrate by a second interconnect,
the first interconnect comprising first bumps arranged at a first pitch, the second interconnect comprises second bumps arranged at a second pitch different from the first pitch, and
at least one of the first and second dies comprising a remapping unit configured to allocate signals arranged in a first order to the first bumps of the first interconnect and/or the second bumps of the second interconnect in a second order different from the first order.
